# EUROPÄISCHE PATENTSCHRIFT

(11) **EP 3 066 486 B1**
(45) Veröffentlichungstag und Bekanntmachung des Hinweises auf die Patenterteilung: **30.05.2018**
(21) Anmeldenummer: 14793106.7
(22) Anmeldetag: 03.11.2014
(51) Int. Cl.: G01R 31/36, B60L 11/18, H01M 10/48

(54) **VORRICHTUNG MIT BATTERIEMODUL UND SCHALTUNGSANORDNUNG ZUR ERKENNUNG EINES ZELLTAUSCHES DURCH UNBEFUGTE**
APPARATUS WITH A BATTERY MODULE AND CIRCUIT ARRANGEMENT FOR DETECTING CELL EXCHANGE BY UNAUTHORIZED PERSONS
DISPOSITIF MUNI D'UN MODULE DE BATTERIE ET D'UN AGENCEMENT DE CIRCUIT PERMETTANT D'IDENTIFIER UN ÉCHANGE D'ÉLÉMENT PAR DES PERSONNES NON AUTORISÉES

(30) Priorität: 07.11.2013 DE 102013222614
(43) Veröffentlichungstag der Anmeldung: 14.09.2016
(73) Patentinhaber: Robert Bosch GmbH, 70442 Stuttgart (DE)
(72) Erfinder: MUSCH, Matthias, 70794 Filderstadt (DE); STEGMUELLER, Holger, 71032 Boeblingen (DE); GAEBLER, Sven, 71638 Ludwigsburg (DE); ACHSTETTER, Andre, 80801 Muenchen (DE)
(86) Internationale Anmeldenummer: PCT/EP2014/073572
(87) Internationale Veröffentlichungsnummer: WO 2015/067560

(56) Entgegenhaltungen:
- CN-A- 102 541 238
- US-A1- 2009 187 781
- US-A1- 2011 261 589

## Beschreibung

### Stand der Technik

Die Erfindung geht aus von einer Vorrichtung mit einem Batteriemodul bestehend aus mindestens einer galvanischen Einzelzelle, mit einem Abgriff einer Modulspannung zwischen einem höchsten Potential des Batteriemoduls und einem Bezugspotential des Batteriemoduls.

Bei Hybrid- oder Elektrofahrzeugen sind Speicherbatterien, beispielsweise Lithium-Ionen-Akkumulatoren, aus einer Vielzahl von Einzelzellen aufgebaut, um eine technisch sinnvolle Spannung bzw. einen technisch sinnvollen Strom bereitstellen zu können. Um Spannung bzw. Strom auch nutzen zu können, besitzen diese Speicherbatterien einen Abgriff, an welchem Verbraucher sowie Überwachungs- und Steuerungseinheiten angeschlossen werden können.

### Aufgabe der Erfindung

Die Aufgabe der Erfindung ist es zu erkennen, ob eine oder mehrere Einzelzellen des Batteriemoduls durch Unbefugte ausgetauscht wurden. Ein derartiger Austausch von Einzelzellen durch Unbefugte kann zur Folge haben, dass Daten, die zur Steuerung des Batteriepacks dem Batterie-Management-Systems (BMS) zugeführten werden, nicht mehr aufeinander abgestimmt sind und somit ein störungsfreier Betrieb nicht mehr gewährleistet werden kann. Außerdem besteht dadurch beim Betrieb eine erhöhte Brand- und Explosionsgefahr, falls beispielsweise von den ursprünglichen Zellen abweichende Zellen eingebaut oder die Zellen falsch angeschlossen werden.

Dokument US2009/0187781 offenbart eine Einrichtung zum Feststellen eines plötzlichen Spannungsabfalles einer Batterie.

### Offenbarung der Erfindung

### Vorteile der Erfindung

Die Erfindung geht aus von einer Vorrichtung mit einem Batteriemodul bestehend aus mindestens einer galvanischen Einzelzelle, mit einem Abgriff einer Modulspannung zwischen einem höchsten Potential des Batteriemoduls und einem Bezugspotential des Batteriemoduls. Der Kern der Erfindung besteht darin, dass die Vorrichtung eine Schaltungsanordnung aufweist, welche mit dem Abgriff der Modulspannung verbunden und dazu eingerichtet ist, bei einem Abfall der Modulspannung auf Null ein Signal auszugeben. Vorteilhaft ist hierbei, dass mittels des ausgegebenen Signals erkannt werden kann, ob eine Zelle getauscht wurde. Somit kann nachvollzogen werden, ob Unbefugte einen Zelltausch vorgenommen haben.

Gemäß der Erfindung ist vorgesehen, dass die Schaltungsanordnung, einen Kondensator, einen Vorwiderstand, einen normalleitenden MOSFET, eine Sicherung sowie einen ersten Schaltungsknoten, einen zweiten Schaltungsknoten, einen dritten Schaltungsknoten und einen vierten Schaltungsknoten aufweist, wobei am ersten Schaltungsknoten das höchste Potential des Batteriemoduls anliegt, und wobei am zweiten Schaltungsknoten das Bezugspotential des Batteriemoduls anliegt, und wobei der Kondensator zwischen dem zweiten Schaltungsknoten und dem dritten Schaltungsknoten angeordnet ist, und wobei der Vorwiderstand zwischen dem ersten Schaltungsknoten und dem dritten Schaltungsknoten angeordnet ist, und wobei die Sicherung zwischen dem dritten Schaltungsknoten und dem vierten Schaltungsknoten angeordnet ist, und wobei der vierte Schaltungsknoten mit dem Drain-Anschluss des MOSFETs verbunden ist, und wobei der Source-Anschluss des MOSFETs mit dem zweiten Schaltungsknoten verbunden ist, und wobei der Gate-Anschluss des MOSFETs mit dem ersten Schaltungsknoten verbunden ist. Vorteilhaft ist hierbei, dass die Schaltungsanordnung aus nur wenigen Bauteilen aufgebaut ist und trotzdem zuverlässig ein Signal ausgibt, falls die Modulspannung auf Null fällt. Eine vorteilhafte Ausgestaltung der Erfindung sieht vor, dass die Vorrichtung eine Verarbeitungseinheit aufweist, welche dazu eingerichtet ist, das Signal zu empfangen und zu verarbeiten. Vorteilhaft ist hierbei, dass die Verarbeitungseinheit das Signal der Schaltungsanordnung dazu nutzen kann, um beispielsweise nach außen hin sichtbar zu machen, dass eine Zelle des Batteriemoduls getauscht wurde.

Eine weitere bevorzugte Ausgestaltung der Erfindung sieht vor, dass die Verarbeitungseinheit dazu eingerichtet ist, das Signal abzuspeichern. Vorteilhaft ist hierbei, dass auch in dem Fall, dass die Schaltungsanordnung wieder in den Anfangszustand zurückversetzt wird, beispielsweise durch Austausch einzelner Schaltteile oder Beeinflussung des Signals, im Nachhinein erkannt werden kann, dass eine Zelle ausgetauscht wurde. Eine weitere vorteilhafte Ausgestaltung der Erfindung sieht vor, dass Leitungen der Schaltungsanordnung im Inneren einer Multi-Layer-Platine angeordnet sind. Vorteilhaft ist hierbei, dass diese Bauweise Manipulationsversuchen entgegen wirkt. Beispielsweise wird dadurch verhindert, dass Leitungen einfach überbrückt und anschließend die Einzelzellen unerkannt durch Unbefugte ausgetauscht werden können.
Eine weitere bevorzugte Ausführungsform der Erfindung sieht vor, dass der Abgriff der Modulspannung mit einem Beschichtungsstoff, insbesondere Lack oder Harz, überzogen ist. Vorteilhaft ist hierbei, dass optisch erkannt werden kann, falls jemand den Abgriff kontaktiert hat, um das Batteriemodul zu überbrücken, um somit Zellen zu tauschen, ohne dass dies von der Schaltungsanordnung erkannt werden konnte. Somit wirkt diese Ausführungsform ebenfalls Manipulationsversuchen entgegen.

### Zeichnungen

Fig. 1 zeigt eine erfindungsgemäße Vorrichtung mit Schaltungsanordnung und Verarbeitungseinheit.
Fig. 2 zeigt ein erstes Ausführungsbeispiel der erfindungsgemäßen Schaltungsanordnung.
Fig. 3 zeigt ein zweites Ausführungsbeispiel der erfindungsgemäßen Schaltungsanordnung.

### Beschreibung von Ausführungsbeispielen

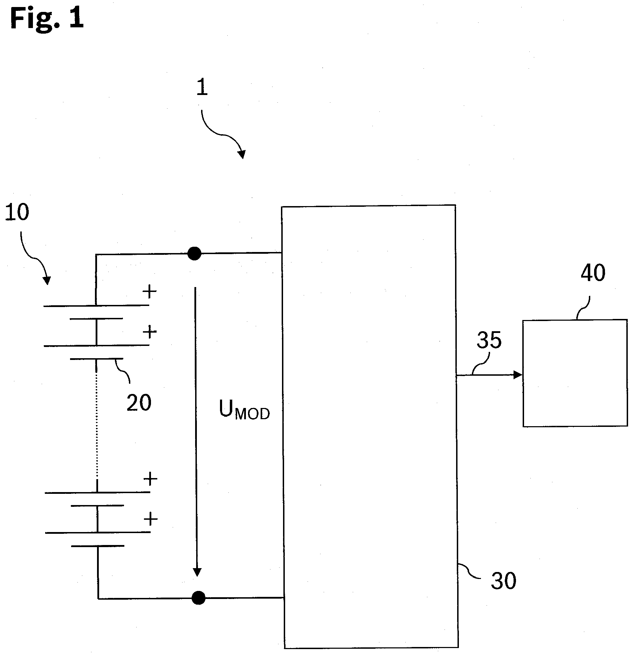

Fig. 1 zeigt eine erfindungsgemäße Vorrichtung mit Schaltungsanordnung und Verarbeitungseinheit. Dargestellt ist eine Vorrichtung 1 bestehend aus einem Batteriemodul 10, einer Schaltungsanordnung 30 und einer Verarbeitungseinheit 40. Das Batteriemodul 10 ist dabei aus einer Vielzahl von seriell geschalteten galvanischen Einzelzellen 20 aufgebaut. Des Weiteren verfügt die Vorrichtung 1 über einen Abgriff zwischen einem höchsten Potential des Batteriemoduls 10 und einem Bezugspotential des Batteriemoduls 10, an dem die Modulspannung U_{MOD} abgegriffen werden kann. Der Abgriff ist mit der Schaltungsanordnung 30 verbunden und stellt somit der Schaltungsanordnung 30 die momentane Modulspannung U_{MOD} zur Verfügung. Die Schaltungsanordnung 30 ist zudem mit der Verarbeitungseinheit 40 verbunden, wodurch die Schaltungsanordnung 30 ein Signal 35 an die Verarbeitungseinheit 40 übermitteln kann.

In einem alternativen Ausführungsbeispiel, welches nicht bildlich dargestellt ist, ist die Verarbeitungseinheit 40 als Mikrocontroller ausgeführt. Der Mikrocontroller empfängt das Signal 35 von der Schaltungsanordnung 40 und kann aus dem Signal 35 schließen, ob die Modulspannung U_{MOD} auf Null gefallen ist und somit eine oder mehrere Einzelzellen 20 ausgetauscht wurden. Wird dies erkannt, kann der Mikrocontroller das erkannte Ereignis alternativ auch in einer internen Speichereinheit abspeichern, damit es auch zu einem späteren Zeitpunkt ausgelesen werden kann. Zudem ist denkbar, dass der Mikrocontroller noch ein Signal nach außen gibt, beispielsweise mittels einer LED oder durch das Anzeigen auf einem Display, um dem Benutzer zu verdeutlichen, dass eine oder mehrere Zellen 20 durch Unbefugte ausgetauscht wurden. In einer weiteren alternativen Ausgestaltung kann das Batteriemodul 10 auch aus beliebig parallel und/oder seriell geschaltenen Einzelzellen 20 aufgebaut sein. Hierbei muss jedoch darauf geachtet werden, dass sichergestellt ist, dass das Batteriemodul 10 beim Entfernen von mindestens einer Einzelzelle 20 spannungslos wird. Als weitere alternative Ausgestaltung ist es denkbar, dass anstelle des Batteriemoduls 10 eine einzige Einzelzelle oder aber ein Batteriepack angeordnet ist.

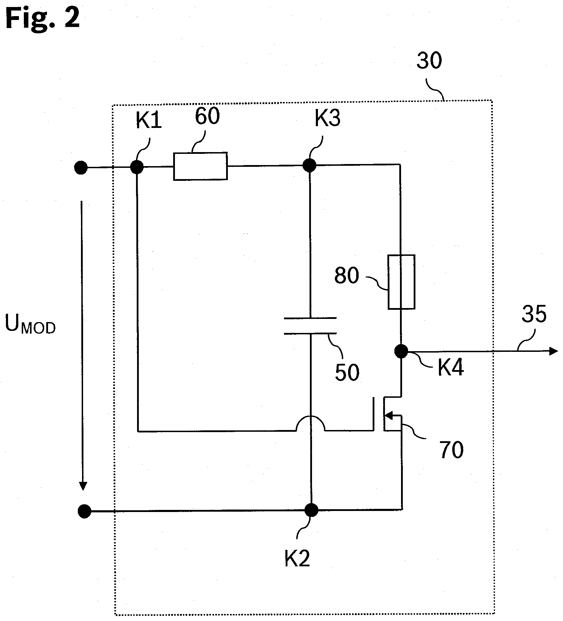

Fig. 2 zeigt ein erstes Ausführungsbeispiel der erfindungsgemäßen Schaltungsanordnung. Die Schaltungsanordnung 30 besteht dabei aus einem Kondensator 50, einem Vorwiderstand 60, einem normalleitenden MOSFET 70, einer Sicherung 80, einem ersten Schaltungsknoten K1, einem zweiten Schaltungsknoten K2, einem dritten Schaltungsknoten K3 und einem vierten Schaltungsknoten K4. Die vom Batteriemodul 10 mittels des Abgriffs bereitgestellte Modulspannung U_{MOD} wird der Schaltungsanordnung 30 zur Verfügung gestellt, in dem der erste Schaltungsknoten K1 mit dem höchsten Potential des Batteriemoduls 10 und der zweite Schaltungsknoten K2 mit dem Bezugspotential des Batteriemoduls 10 verbunden ist. Des Weiteren ist zwischen dem zweiten Schaltungsknoten K2 und dem dritten Schaltungsknoten K3 der Kondensator 50 angeordnet. Zudem ist zwischen dem ersten Schaltungsknoten K1 und dem dritten Schaltungsknoten K3 der Vorwiderstand 60 angeordnet, über den sich der Kondensator 50 auflädt. Der MOSFET 70 ist drainseitig mit dem vierten Schaltungsknoten K4, source-seitig mit dem zweiten Schaltungsknoten K2 und gate-seitig mit dem ersten Schaltungsknoten K1 verbunden. Außerdem ist die Sicherung 80 zwischen dem dritten Schaltungsknoten K3 und dem vierten Schaltungsknoten K4 angeordnet. Am vierten Schaltungsknoten K4 ist zudem ein Abgriff für das Signal 35 angeordnet.

Die Schaltungsanordnung 30 nach Fig. 2 funktioniert im Betrieb so, dass der Kondensator 50 von der Modulspannung U_{MOD} über den Vorwiderstand 60 aufgeladen wird. Die vorhandene Modulspannung U_{MOD} liegt auch am Gate des normalleitenden MOSFETs 70 an, wodurch dieser sperrt. Fällt nun die Modulspannung U_{MOD} auf Null, weil beispielsweise eine der in Serie geschalteten Zellen 20 ausgetauscht wird, so ist auch die Gatespannung gleich Null, und der MOSFET 70 wird leitend. Daraufhin entlädt sich der Kondensator 50 über den nun leitenden MOSFET 70 und über die Sicherung 80. Bei einer ausreichend großen Kapazität des Kondensators 50 wird dabei die Sicherung 80 ausgelöst, was wiederum zu einem Spannungsabfall durch die nun hochohmige Sicherung führt, welcher als Signal 35 abgegriffen wird. Somit kann mittels des Signals 35 darauf geschlossen werden, ob die Modulspannung U_{MOD} auf Null abgefallen ist, was wiederum einen möglichen Zelltausch darstellt.

In einem alternativen Ausführungsbeispiel, welches nicht bildlich dargestellt ist, ist die Sicherung 80 als Schmelzsicherung ausgeführt. Dadurch kann bereits an Hand einer optischen Kontrolle geprüft werden, ob die Sicherung 80 ausgelöst hat, was ein deutliches Anzeichen dafür ist, dass die Modulspannung U_{MOD} auf Null abgefallen ist und somit eine oder mehrere Einzelzellen 20 ausgetauscht wurden. Alternativ ist es auch denkbar, eine selbstrückstellende Sicherung oder ein Leitungsschutzschalter einzusetzen, wodurch mehrere Zelltäusche erkannt werden könnten. Zudem müsste nach dem Austausch von Einzelzellen 20 durch Unbefugte, die Sicherung 80 nicht ausgetauscht werden, um die Schaltungsanordnung 30 wieder in den Zustand zu bringen, wie er bei Inbetriebnahme der Schaltungsanordnung 30 gegeben war.

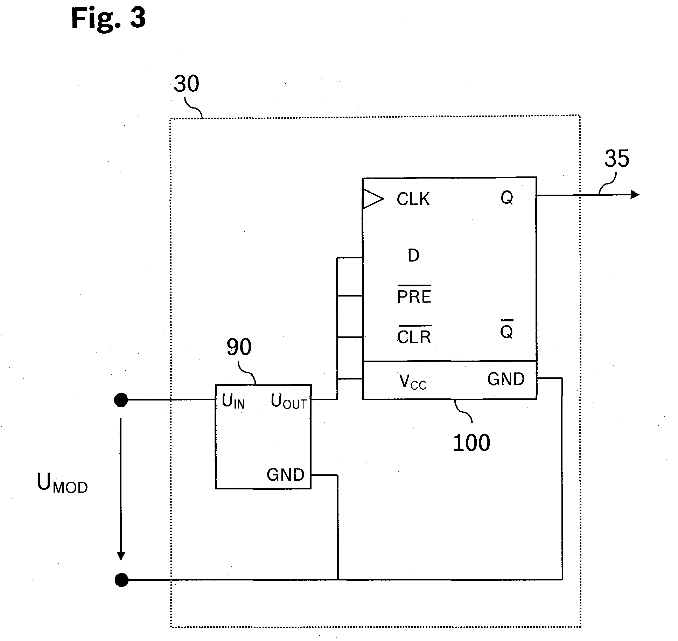

Fig. 3 zeigt ein zweites Ausführungsbeispiel der erfindungsgemäßen Schaltungsanordnung. Die Schaltungsanordnung 30 besteht dabei aus einem Spannungsregler 90 und einem Flipflop 100 mit asynchronen Steuereingängen. Dem Eingang des Spannungsreglers 90 ist mit dem höchsten Potential des Batteriemoduls 10 verbunden. Zudem nutzt der Spannungsregler 90 das Bezugspotential des Batteriemoduls 10 als Masse. Der Ausgang des Spannungsreglers 90 ist mit dem Versorgungseingang, dem Signaleingang, sowie dem negierten Rücksetzvorgabewerteingang und dem negierten Startvorgabewerteingang des Flipflops 100 verbunden. Der Ausgang des Flipflops 100 ist aus der Schaltungsanordnung 30 herausgeführt und stellt das Signal 35 dar. Des Weiteren nutzt der Flipflop 100 ebenfalls das Bezugspotential des Batteriemoduls 10 als Masse.

Die Schaltungsanordnung 30 nach Fig. 3 funktioniert im Betrieb so, dass bei Inbetriebnahme der Flipflop 100 durch ein Taktsignal gesetzt wird und somit der Ausgang des Flipflops 100, welcher das Signal 35 darstellt, einen definierten Zustand aufweist. Der Spannungsregler 90 dient dabei dazu, dass trotz Schwankungen der Modulspannung U_{MOD}, welche durch Auf- und Entladevorgänge des Batteriemoduls 10 ausgelöst werden, eine konstante Versorgungsspannung für den Flipflop 100 bereitgestellt wird. Hierdurch lassen sich mögliche Zustandsänderung am Ausgang des Flipflops 100 vermeiden, welche durch Spannungsschwankungen an den Eingängen des Flipflops 100 verursacht würden. Fällt die Spannung am Eingang des Spannungsreglers jedoch auf Grund eines Zelltausches auf Null, werden auch die vom Spannungsregler versorgten Eingänge des Flipflops auf Null gezogen. Ein erneutes Anlegen der Versorgungsspannung verändert anschließend den Ausgangszustand des Flipflops 100, wodurch sich der Wert des Signals 35 ändert. Durch die Abweichung des Signals 35 vom bei Inbetriebnahme der Schaltunganordnung eingestellten Erwartungswert kann man darauf schließen, dass die Modulspannung U_{MOD} auf Null abgefallen ist, was wiederum einen möglichen Zelltausch signalisiert.

## Patentansprüche

1. Vorrichtung (1) mit einem Batteriemodul (10) bestehend aus mindestens einer galvanischen Einzelzelle (20), mit einem Abgriff einer Modulspannung (U_{MOD}) zwischen einem höchsten Potential des Batteriemoduls (10) und einem Bezugspotential des Batteriemoduls (10),
**dadurch gekennzeichnet, dass**
die Vorrichtung (1) eine Schaltungsanordnung (30) aufweist, welche mit dem Abgriff der Modulspannung (U_{MOD}) verbunden und dazu eingerichtet ist, bei einem Abfall der Modulspannung (U_{MOD}) auf Null ein Signal (35) auszugeben, wobei die Schaltungsanordnung (30), einen Kondensator (50), einen Vorwiderstand (60), einen normalleitenden MOSFET (70), eine Sicherung (80) sowie einen ersten Schaltungsknoten (K1), einen zweiten Schaltungsknoten (K2), einen dritten Schaltungsknoten (K3) und einen vierten Schaltungsknoten (K4) aufweist,
- wobei am ersten Schaltungsknoten (K1) das höchste Potential des Batteriemoduls (10) anliegt, und
- wobei am zweiten Schaltungsknoten (K2) das Bezugspotential des Batteriemoduls (10) anliegt, und
- wobei der Kondensator (50) zwischen dem zweiten Schaltungsknoten (K2) und dem dritten Schaltungsknoten (K3) angeordnet ist, und
- wobei der Vorwiderstand (60) zwischen dem ersten Schaltungsknoten (K1) und dem dritten Schaltungsknoten (K3) angeordnet ist, und
- wobei die Sicherung (80) zwischen dem dritten Schaltungsknoten (K3) und dem vierten Schaltungsknoten (K4) angeordnet ist, und
- wobei der vierte Schaltungsknoten (K4) mit dem Drain-Anschluss des MOSFETs (70) verbunden ist, und
- wobei der Source-Anschluss des MOSFETs (70) mit dem zweiten Schaltungsknoten (K2) verbunden ist, und
- wobei der Gate-Anschluss des MOSFETs mit dem ersten Schaltungsknoten (K1) verbunden ist.

2. Vorrichtung (1) nach Anspruch 1, **dadurch gekennzeichnet, dass** die Vorrichtung (1) eine Verarbeitungseinheit (40) aufweist, welche dazu eingerichtet ist, das Signal (35) zu empfangen und zu verarbeiten.

3. Vorrichtung (1) nach Anspruch 2, **dadurch gekennzeichnet, dass** die Verarbeitungseinheit (40) dazu eingerichtet ist, das Signal (35) abzuspeichern.

4. Vorrichtung (1) nach einem der vorhergehenden Ansprüche, **dadurch gekennzeichnet, dass** Leitungen der Schaltungsanordnung (30) im Inneren einer Multi-Layer-Platine angeordnet sind.

5. Vorrichtung (1) nach einem der vorhergehenden Ansprüche, **dadurch gekennzeichnet, dass** der Abgriff der Modulspannung (U_{MOD}) mit einem Beschichtungsstoff (110), insbesondere Lack oder Harz, überzogen ist.

## Claims

1. Apparatus (1) having a battery module (10) consisting of at least one individual galvanic cell (20), having a tap of a module voltage (U_{MOD}) between a highest potential of the battery module (10) and a reference potential of the battery module (10),
**characterized in that**
the apparatus (1) has a circuit arrangement (30), which is connected to the tap of the module voltage (U_{MOD}) and is configured to emit a signal (35) if the module voltage (U_{MOD}) drops to zero, wherein the circuit arrangement (30) has a capacitor (50), a series resistor (60), a normally conducting MOSFET (70), a fuse (80) as well as a first circuit node (K1), a second circuit node (K2), a third circuit node (K3) and a fourth circuit node (K4),
- wherein the highest potential of the battery module (10) is applied at the first circuit node (K1), and
- wherein the reference potential of the battery module (10) is applied at the second circuit node (K2), and
- wherein the capacitor (50) is arranged between the second circuit node (K2) and the third circuit node (K3), and
- wherein the series resistor (60) is arranged between the first circuit node (K1) and the third circuit node (K3), and
- wherein the fuse (80) is arranged between the third circuit node (K3) and the fourth circuit node (K4), and
- wherein the fourth circuit node (K4) is connected to the drain terminal of the MOSFET (70), and
- wherein the source terminal of the MOSFET (70) is connected to the second circuit node (K2), and
- wherein the gate terminal of the MOSFET is connected to the first circuit node (K1).

2. Apparatus (1) according to Claim 1, **characterized in that** the apparatus (1) has a processing unit (40), which is configured to receive and to process the signal (35).

3. Apparatus (1) according to Claim 2, **characterized in that** the processing unit (40) is configured to store the signal (35).

4. Apparatus (1) according to one of the preceding claims, **characterized in that** lines of the circuit arrangement (30) are arranged inside a multi-layer printed circuit board.

5. Apparatus (1) according to one of the preceding claims, **characterized in that** the tap of the module voltage (U_{MOD}) is covered with a coating material (110), in particular lacquer or resin.

## Revendications

1. Dispositif (1) comprenant un module de batterie (10) constitué d'au moins une cellule individuelle (20) galvanique, comprenant une prise d'une tension de module (U_{MOD}) entre un potentiel maximal du module de batterie (10) et un potentiel de référence du module de batterie (10),
**caractérisé en ce que**
le dispositif (1) possède un arrangement de circuit (30) qui est relié à la prise de la tension de module (U_{MOD}) et qui est conçu pour délivrer un signal (35) dans le cas où la tension de module (U_{MOD}) chute à zéro, l'arrangement de circuit (30) possédant un condensateur (50), une résistance série (60), un MOSFET (70) à conduction normale, un fusible (80) ainsi qu'un premier noeud de circuit (K1), un deuxième noeud de circuit (K2), un troisième noeud de circuit (K3) et un quatrième noeud de circuit (K4),
- le potentiel maximal du module de batterie (10) étant présent au niveau du premier noeud de circuit (K1), et
- le potentiel de référence du module de batterie (10) étant présent au niveau du deuxième noeud de circuit (K2), et
- le condensateur (50) étant disposé entre le deuxième noeud de circuit (K2) et le troisième noeud de circuit (K3), et
- la résistance série (60) étant disposée entre le premier noeud de circuit (K1) et le troisième noeud de circuit (K3), et
- le fusible (80) étant disposé entre le troisième noeud de circuit (K3) et le quatrième noeud de circuit (K4), et
- le quatrième noeud de circuit (K4) étant relié à la borne de drain du MOSFET (70), et
- la borne de source du MOSFET (70) étant reliée au deuxième noeud de circuit (K2), et
- la borne de gâchette du MOSFET étant reliée au premier noeud de circuit (K1).

2. Dispositif (1) selon la revendication 1,
**caractérisé en ce que** le dispositif (1) possède une unité de traitement (40) qui est conçue pour recevoir et traiter le signal (35).

3. Dispositif (1) selon la revendication 2,
**caractérisé en ce que** l'unité de traitement (40) est conçue pour mémoriser le signal (35).

4. Dispositif (1) selon l'une des revendications précédentes, **caractérisé en ce que** les lignes de l'arrangement de circuit (30) sont disposées à l'intérieur d'une platine multicouche.

5. Dispositif (1) selon l'une des revendications précédentes, **caractérisé en ce que** la prise de la tension de module (U_{MOD}) est recouverte d'une substance de revêtement (110), notamment de vernis ou de résine.
